# FASCICULE DE BREVET EUROPEEN

(11) **EP 2 457 326 B1**
(45) Date de publication et mention de la délivrance du brevet: **29.05.2013**
(21) Numéro de dépôt: 10735282.5
(22) Date de dépôt: 22.07.2010
(51) Int. Cl.: H03K 19/003, H03F 3/21, H03F 3/60

(54) **STRUCTURE HYPERFRÉQUENCES DE COMMUTATION À AMPLIFICATEUR DISTRIBUÉ AVEC ENTRÉE D'INJECTION DE SIGNAL DE TEST**
HOCHFREQUENZSCHALTER MIT VERTEILTEN VERSTÄRKERN UND EINGANG FÜR EIN TESTSIGNAL
HIGHFREQUENCY SWITCHING DEVICE WITH DISTRIBUTED AMPLIFIERS AND TEST SIGNAL INPUT

(30) Priorité: 24.07.2009 FR 0903659
(43) Date de publication de la demande: 30.05.2012
(73) Titulaire: THALES, 92200 Neuilly-sur-Seine (FR)
(72) Inventeur: DUEME, Philippe, 91400 Orsay (FR); PLAZE, Jean-Phillippe, 78390 Bois d'Arcy (FR); DEQUEN, Thierry, 78310 Marepas (FR)
(74) Mandataire: Lucas, Laurent Jacques
(86) Numéro de dépôt international: PCT/EP2010/060605
(87) Numéro de publication internationale: WO 2011/009905

(56) Documents cités:
- US-A1- 2003 201 830
- US-A1- 2006 077 102
- US-A1- 2006 108 664

## Description

L'invention concerne les circuits dits multifonctions utilisés dans les systèmes hyperfréquences de réception et/ou d'émission fonctionnant dans une large bande de fréquences.

Pour certaines applications, la fonction de réception d'un signal à partir d'une antenne doit comporter un dispositif permettant de tester son fonctionnement en cours de mission. Le principe de ce dispositif (dit « de test » ou « de calibrage » ou « d'auto-calibrage ») consiste à injecter à l'entrée du circuit de réception un signal de test en lieu et place du signal normalement reçu par l'antenne.

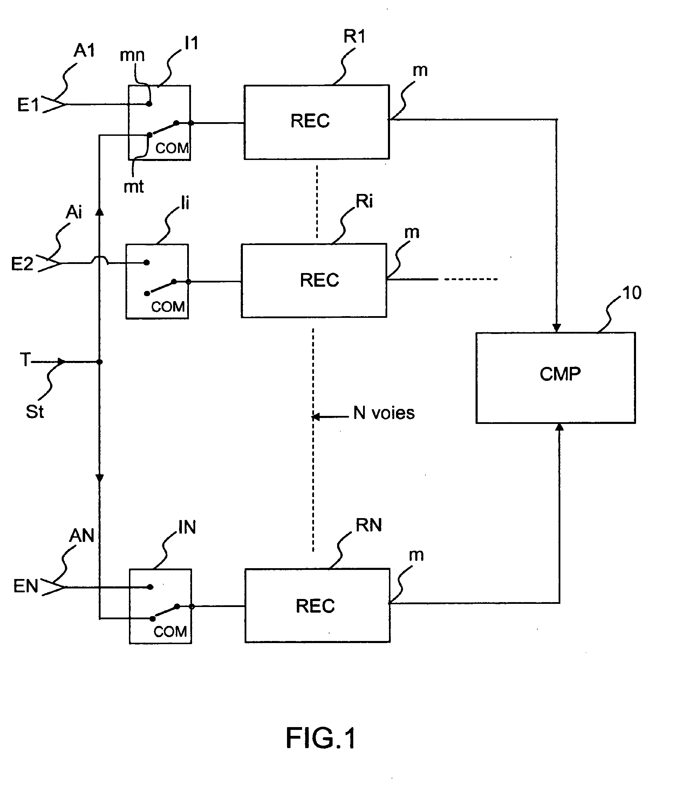

La figure 1 montre un système de réception de l'état de l'art intégrant un dispositif de test des paramètres de réception comportant N voies de réception. Chaque voie de réception comporte un récepteur hyperfréquences REC R1, R2, ...Ri, ...RN, ayant une entrée RF connectée, par l'intermédiaire d'un interrupteur inverseur I1, I2, Ii, ...IN, soit à une antenne A1, A2, ...Ai, ...AN, soit à une sortie d'un générateur fournissant un signal de calibrage ou d'autotest St.

Chaque récepteur REC comporte une sortie m fournissant des mesures d'amplitude et de phase du signal de calibrage St appliqué à l'entrée RF du récepteur REC. Ces mesures en sortie des récepteurs sont traitées par un dispositif CMP 10 permettant d'établir des écarts de paramètres entre voies de réception.

Chaque interrupteur/inverseur d'une voie de réception respective est commandé soit dans une position mn dite en « mode normal » connectant l'entrée du récepteur avec l'antenne, soit dans une position mt dite en « mode test » connectant l'entrée du récepteur au générateur de signal de calibrage ou d'autotest.

L'utilisation d'un interrupteur/inverseur en entrée du récepteur REC pour choisir soit le signal utile reçu par l'antenne, soit le signal de test Ts a un impact immédiat sur la sensibilité de réception. En effet des pertes radiofréquences RF sont introduites, notamment dans les cas d'utilisation de commutateurs électroniques. Ces pertes peuvent atteindre 3dB dans le cas de réalisations compactes.

Dans d'autres réalisations les interrupteurs/inverseurs sont des relais électromécaniques comportant des contacts mécaniques.

Des coupleurs large bande sans commutation mécanique sont parfois utilisés pour le choix du signal mais ces solutions ont l'inconvénient de présenter des volumes importants incompatibles avec une miniaturisation des systèmes de réception.

La solution utilisée dans les systèmes existants consistant à injecter le signal de test St par l'intermédiaire d'un coupleur directif, en connectant, par exemple, le signal d'antenne sur la voie directe du coupleur et le signal de test sur la voie couplée peut présenter des pertes moindres qu'un interrupteur/inverseur compact, mais au prix d'un volume et d'un poids importants. En outre, cette solution utilisant un coupleur directif, est difficilement applicable aux systèmes de réception fonctionnant sur une très large bande de fréquences.

Pour résumer, les solutions traditionnelles utilisables pour l'injection d'un signal de test dans les dispositifs de réception ont des inconvénients (pertes, poids, encombrement) et seront d'autant plus pénalisantes que la largeur de bande de fréquences de fonctionnement du récepteur sera importante.

Pour limiter les inconvénients des dispositifs de commutation hyperfréquences de l'état de l'art, l'invention propose une structure électronique hyperfréquences de commutation comportant au moins une entrée de signal utile destinée à recevoir un signal utile, une entrée de signal de test destiné à recevoir un signal de test, au moins une sortie de signal hyperfréquences,
caractérisé en ce qu'elle comporte n amplificateurs distribués, n étant supérieur ou égal à 1, pour former q voies de signal, q étant supérieur ou égal à 2, chaque amplificateur distribué comportant un groupe de cellules amplificatrices distribuées entre une ligne d'entrée et une ligne de sortie,
la ligne d'entrée ayant à une des ses extrémités un accès d'entrée de signal hyperfréquences (1, 11) et, à l'autre extrémité, un accès de charge (4, 41),
la ligne de sortie Ls ayant à une de ses extrémités, du côté de l'accès de charge de la ligne d'entrée, un accès (2, 21, 22) de sortie de signal hyperfréquences et à l'autre extrémité un accès (3, 31) d'entrée de signal hyperfréquences,
l'accès d'entrée de signal hyperfréquences d'au moins d'une des ligne d'entrée d'un amplificateur distribué étant l'entrée de signal utile, l'accès d'entrée de signal hyperfréquences d'une autre des lignes étant l'entrée de signal de test, l'accès de sortie de signal hyperfréquences d'au moins une des lignes de sortie étant la sortie de signal hyperfréquences,
chacune des cellules amplificatrices comportant une entrée de commande pour mettre lesdites cellules amplificatrices d'un groupe indépendamment d'un autre groupe, soit dans un état amplificateur, soit dans un état bloqué, pour effectuer une transmission à la sortie de signal hyperfréquences, soit du signal utile amplifié, soit du signal de test,
une unité de commande UC pour commander les cellules amplificatrices de chacun des groupes, soit dans l'état amplificateur, soit dans l'état bloqué.

Avantageusement, la structure comporte un seul amplificateur distribué (n=1) pour former deux voies de signal (q=2), une voie de signal amplificatrice pour un signal d'entrée et, une voie de signal non amplificatrice (voie passive) pour un signal de test, l'accès d'entrée de signal hyperfréquences de la ligne de sortie étant l'entrée de signal de test, l'accès de sortie de signal hyperfréquences de la ligne de sortie étant la sortie de signal hyperfréquences fournissant, soit le signal utile amplifié par l'amplificateur distribue lorsque les cellules amplificatrices dudit amplificateur distribué sont mises dans l'état amplificateur, soit le signal de test transmis par la ligne de sortie lorsque lesdites cellules amplificatrices sont mises dans l'état bloqué et que le signal de test est appliqué à l'entrée de signal de test de ladite ligne de sortie.

Dans une réalisation, la structure comporte un premier et un deuxième amplificateurs distribués symétriques par rapport à une ligne de sortie commune pour former deux voies de signal amplificatrices (q=2), une voie pour le signal utile et une voie pour le signal de test, les amplificateurs distribués ayant respectivement, un premier et un deuxième groupes de cellules amplificatrices, une première et une deuxième lignes d'entrée,
l'accès d'entrée de signal hyperfréquences de la ligne de sortie commune étant connectée à une charge de ligne de sortie, l'accès de sortie de signal hyperfréquences de la ligne de sortie étant la sortie de signal hyperfréquences,
l'entrée de signal utile étant l'accès d'entrée de la première ligne d'entrée formant avec le premier groupe de cellules amplificatrices et la ligne de sortie commune (Ls) le premier amplificateur distribuée du signal utile,
l'entrée de signal test étant l'accès d'entrée de la deuxième ligne d'entrée (Le2) formant avec le deuxième groupe de cellules amplificatrices et la ligne de sortie commune (Ls) le deuxième amplificateur distribuée du signal de test (St),
la sortie (S1) de signal hyperfréquences fournissant, soit le signal utile (Ue) amplifié lorsque les cellules amplificatrices du premier groupe sont mises dans l'état amplificateur et celles du deuxième groupe dans l'état bloqué, soit le signal de test (St) lorsque les cellules amplificatrices du premier groupe sont mises dans l'état bloqué et celles du deuxième groupe dans l'état amplificateur et que le signal de test (St) est appliqué l'accès d'entrée de la deuxième ligne d'entrée (Le2).

Dans une autre réalisation, la structure comporte un premier et un deuxième amplificateurs distribués symétriques par rapport à une ligne de sortie commune pour former trois voies de signal (q=3), une première voie amplificatrice pour un premier signal utile, une deuxième voie amplificatrice pour un deuxième signal utile et une troisième voie passive pour le signal de test, les amplificateurs distribués ayant respectivement un premier et un second groupes de cellules amplificatrices, une première et une deuxième lignes d'entrée,

l'accès (3) d'entrée de signal hyperfréquences de la ligne de sortie commune (Ls1) étant l'entrée (T) de signal de test (St), l'accès de sortie (2) de signal hyperfréquences de la ligne de sortie commune (Ls1) étant la sortie (S1) de signal hyperfréquences,
l'entrée d'un premier signal utile étant l'accès d'entrée de la première ligne d'entrée (Le1) formant avec le premier groupe (g1) de cellules amplificatrices et la ligne de sortie commune (Ls1) le premier amplificateur distribuée du premier signal utile (Ue1),
l'entrée (E2) d'un deuxième signal utile (Ue2) étant l'accès d'entrée (12) de la deuxième ligne d'entrée (Le2) formant avec le deuxième groupe de cellules amplificatrices et la ligne de sortie commune (Ls1) le deuxième amplificateur distribuée du deuxième signal utile (Ue2),
la sortie hyperfréquences (S1) fournissant, soit le premier signal utile (Ue1) amplifié lorsque les cellules amplificatrices du premier groupe sont mises dans l'état amplificateur et celles du deuxième groupe dans l'état bloqué, soit le deuxième signal utile (Ue2) amplifié lorsque les cellules amplificatrices du premier groupe sont mises dans l'état bloqué et celles du deuxième groupe dans l'état amplificateur, soit le signal de test (St) lorsque les cellules amplificatrices du premier et du deuxième groupes sont mises dans l'état bloqué et que le signal de test est appliqué à l'accès d'entrée de signal de la ligne de sortie (Ls1) commune.

Dans une autre réalisation, la structure comporte, outre le premier et le deuxième amplificateurs distribués formant un premier sous-ensemble à amplificateurs distribués comportant la sortie de signal hyperfréquences (S1), un troisième et un quatrième amplificateurs distribués formant un deuxième sous-ensemble à amplificateurs distribués symétrique du premier par rapport à la deuxième ligne d'entrée commune aux deux sous ensembles pour former quatre voies de signal amplificatrices (q=4), deux voies amplificatrices chacune amplifiant un respectif signal utile et deux autres voies amplificatrices pour le signal de test, les troisième et quatrième amplificateurs distribués comportant respectivement un troisième et quatrième groupes de cellules amplificatrices, le deuxième sous-ensemble comportant une autre sortie de signal hyperfréquences,

les deux sous-ensembles symétriques ayant, la deuxième ligne d'entrée commune, l'accès d'entrée de la deuxième ligne d'entrée commune étant l'entrée de signal de test,
l'autre sortie hyperfréquences (S2) du deuxième sous-ensemble (ES2) fournissant :
soit un autre signal utile (Ue2) amplifié appliqué à une autre entrée (E2) de la première ligne d'entrée (Le1) du deuxième sous-ensemble (ES2), lorsque les cellules amplificatrices du quatrième groupe de cellules amplificatrices du deuxième sous-ensemble (ES2) sont mises dans l'état amplificateur et celles du troisième groupe de ce deuxième sous-ensemble (ES2) dans l'état bloqué,
soit le signal de test (St) lorsque les cellules amplificatrices du troisième groupe (g3) de cellules amplificatrices du deuxième sous-ensemble (ES2) sont mises dans l'état amplificateur et celles du quatrième groupe (g4) groupe de ce deuxième sous-ensemble (ES2) dans l'état bloqué et que le signal de test (St) est appliqué l'accès d'entrée de la deuxième ligne d'entrée commune (Le2c).

Dans une autre réalisation, les accès de charge des lignes d'entrée (Le, Le1, Le2) sont connectés à une impédance caractéristique desdites lignes d'entrée.

L'invention sera mieux comprise à l'aide d'exemples de réalisations de structures électroniques hyperfréquences de commutation en référence aux dessins indexés dans lesquels :
- la figure 1, déjà décrite, montre un système de réception de l'état de l'art intégrant un dispositif de test des paramètres de réception ;
- la figure 2a représente un schéma de principe d'un amplificateur distribué ;
- la figure 2b montre un schéma de principe général de la structure électronique hyperfréquences de commutation selon l'invention ;
- la figure 3 montre un synoptique d'une fonction à réaliser par la structure de commutation selon l'invention ;
- la figure 4 montre une première structure de commutation à amplificateur distribué, selon l'invention, comportant une entrée de test ;
- la figure 5 montre une structure de commutation selon l'invention à double amplificateur distribué ;
- la figure 6 montre un synoptique d'une autre fonction à réaliser par la structure de commutation selon l'invention ;
- la figure 7 montre une variante de la structure de commutation double à amplificateur distribué de la figure 5 ;
- la figure 8 montre un synoptique d'une autre fonction électronique comportant une structure de commutation à double signal ;
- la figure 9 montre une structure électronique hyperfréquences de commutation selon l'invention à amplificateurs distribués à double signal ;
- la figure 10a montre le fonctionnement dit normal de la structure de commutation de la figure 9 ;
- la figure 10b montre le fonctionnement dit de test de la structure de commutation de la figure 9 ;
- la figure 11a montre un exemple de réalisation d'un circuit multifonction comportant une structure électronique hyperfréquences de commutation représentée à la figure 9, et ;
- la figure 11b montre, à titre d'exemple, le dessin du masque du circuit multifonction de la figure 11a.

L'idée proposée pour réaliser la structure de commutation selon l'invention est d'utiliser une structure active ayant les propriétés d'un amplificateur distribué couramment utilisé dans les applications à large bande passante.

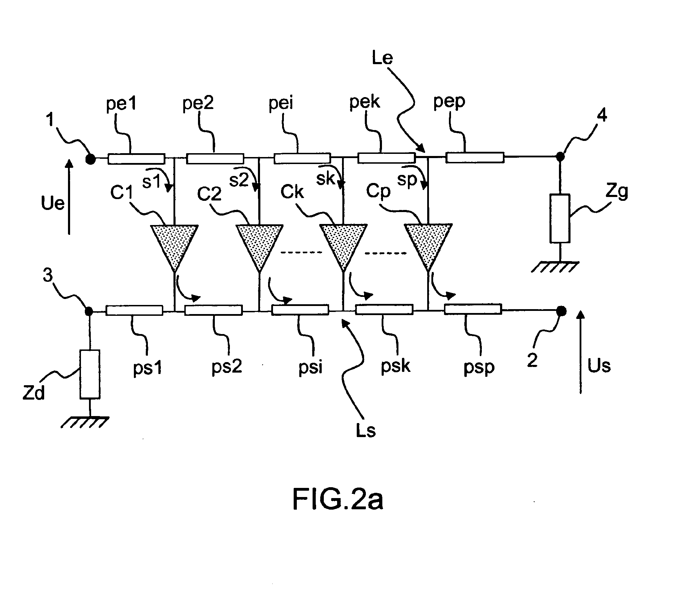

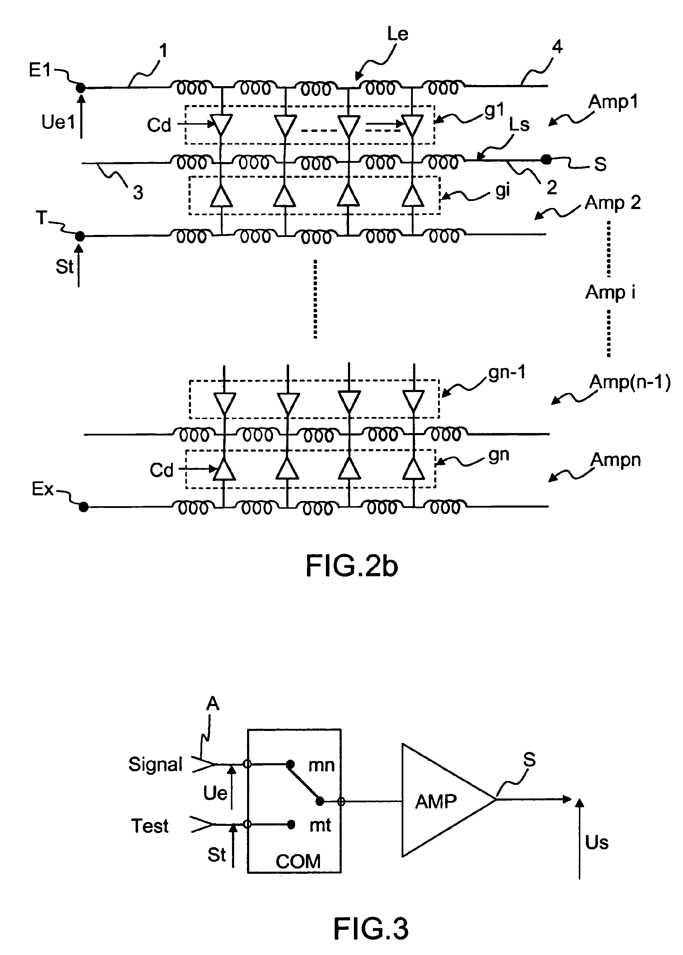

La figure 2a représente un schéma de principe d'un amplificateur distribué comportant essentiellement une ligne d'entrée Le couplée activement à une ligne de sortie Ls par des cellules amplificatrices actives C1, C2, ...Ck, ...Cp, représentées par des triangles sur la figure 2.

Chacune des cellules actives est réalisée soit à partir d'un transistor seul, par exemple, un transistor à effet de champ ou FET, soit à partir d'un montage associant plusieurs transistors, par exemple, un montage Darlington ou un montage cascode.

Par couplage actif, on entend qu'un signal d'entrée Ue injecté à un accès d'entrée 1 sur la ligne d'entrée Le de l'amplificateur distribué, se propage le long de celle-ci en se décomposant en signaux élémentaires s1, s2, ...sk, ...sp. Chaque signal élémentaire est amplifié par une cellule amplificatrice active C1, C2, ...Ck, ...Cp, respective puis, les signaux élémentaires amplifiés en sortie des cellules actives se recombinent en phase sur la ligne de sortie Ls pour fournir à un accès de sortie 2 de la ligne de sortie Ls une tension de sortie Us.

La ligne d'entrée Le est refermée par son accès de charge 4 sur une impédance de charge Zg et la ligne de sortie Ls sur une autre impédance de charge Zd connectée à l'accès 3 de signal d'entrée dont la valeur est en principe égale à l'impédance caractéristique de la ligne considérée.

Dans le cas d'un montage à base de transistors à effet de champ, la ligne d'entrée Le est communément appelée ligne de grille et la ligne de sortie Ls, ligne de drain.

Concrètement de façon connue, ces lignes sont réalisées par l'association d'une suite d'éléments passifs d'entrée pe1, pe2 .,..pek, ...pep, pour la ligne d'entrée Le et une suite d'éléments passifs de sortie ps1, ps2, ...psk, ...psp, pour la ligne de sortie Ls. Par exemple ces éléments d'entrée et de sortie sont les capacités internes des transistors (auxquelles on peut également associer des capacités externes en série ou en parallèle suivant le besoin) et d'inductances, ou éventuellement des tronçons de ligne placés entre les cellules actives (avec éventuellement un effet de mutuelle inductance entre elles).

Ces lignes d'entrée Le et de sortie Ls ont un comportement très constant depuis les fréquences basses (le continu en théorie, les limitations pratiques venant des circuits de polarisation des transistors) jusqu'à des fréquences de coupures liées à la tailles des transistors, donc aux caractéristiques fondamentales du circuit (gain, puissance de sortie, etc), ce qui confère à ce type de circuit distribué un comportement dit « large bande».

Dans le cas d'une réalisation d'un circuit distribué utilisant des puces hyperfréquences ou MMIC pour « Microwave Monolithic Integrated Circuit » en langue anglaise, les connexions des impédances de charge Zg, Zd se font généralement sur la puce et par conséquent les accès 4, 3 de charge desdites lignes d'entrée Le et sortie Ls connectées aux impédances de charge respectives ne sont pas disponibles.

Il est cependant possible de remplacer les impédances de charge Zg, Zd par autre chose qu'une simple résistance, par exemple un accès de charge sur lequel on connectera une charge utile dont l'impédance devra correspondre à la bonne impédance caractéristique. Si par exemple on connecte une porte sur l'accès 4 de charge de la ligne d'entrée Le, on dispose d'une sortie annexe non amplifiée, atténuée des pertes de la ligne de transmission Le par rapport au signal d'entrée Ue.

L'invention propose une série de solutions, toutes basées sur une utilisation particulière de la structure de base de l'amplificateur distribué de la figure 2a ou sur une extension de cette structure de base. Ces solutions diffèrent en particulier par la configuration de la fonction à réaliser, selon que l'injection d'un signal de test St doit être associée à un ou plusieurs signaux. Nous envisagerons en détail par la suite deux cas :
● Injection d'un signal de test associé à un signal de réception unique,
● Injection d'un signal de test commun associé à deux signaux de réception (cas d'un système selon la Figure 1 comportant deux voies, N=2).

La figure 2b montre un schéma de principe général de la structure électronique hyperfréquences de commutation selon l'invention comportant au moins une entrée E1"...Ex de signal utile, une entrée T de signal de test, au moins une sortie S de signal hyperfréquences.

La structure électronique hyperfréquences générale comporte n amplificateurs distribués, n étant un nombre supérieur ou égal à 1, pour former q voies de signal hyperfréquences, q étant un nombre égal ou supérieur à 2. Dans certaines réalisations de la structure hyperfréquences, les voies sont toutes amplificatrices des signaux, dans d'autres réalisations la structure peut comporter des voies amplificatrices des signaux et des voies non amplificatrices (voies passives),

Le nombre q de voies (au moins 2), comme cela est décrit par la suite, dépend de la configuration et de l'utilisation souhaitée de la structure électronique hyperfréquences. Dans le cas ou q = n et au moins égal à 2 toutes les voies sont amplificatrices.

Chaque amplificateur distribué Amp1,...Ampi,...Ampn comporte un groupe g1, g2, ...gi, ...gn, de cellules amplificatrices Cs1, Cs2, ...Csk, ...Csp, p étant le nombre de cellules amplificatrices, distribuées entre une ligne d'entrée Le et une ligne de sortie Ls, la ligne d'entrée Le ayant à une des ses extrémités un accès d'entrée 1 de signal hyperfréquences et à l'autre extrémité un accès 4 de charge de ligne d'entrée, la ligne de sortie Ls comportant à une de ses extrémités, du côté de l'accès 1 d'entrée de la ligne d'entrée Le, un accès d'entrée 3 de signal hyperfréquences et à l'autre extrémité un accès 4 de sortie hyperfréquences.

L'accès 1 d'au moins d'une des lignes d'entrée d'un amplificateur distribué étant l'entrée E de signal utile, un accès d'entrée d'une autre des lignes de la structure étant l'entrée T de signal de test.

L'accès de sortie 4 d'au moins une ligne de sortie Ls comportant la sortie S de signal hyperfréquences qui peut être soit le signal utile Ue amplifié, soit le signal test St amplifié ou non selon les configurations possibles de la structure selon l'invention.

Chacune des cellules amplificatrices Cs1, Cs2, ...Csk, ...Csp, comporte une entrée de commande Cd pour mettre lesdites cellules amplificatrices de chacun des groupes g1, g2, ...gi, ...gn, indépendamment, soit dans un état amplificateur, soit dans un état bloqué, pour effectuer une transmission à la sortie S hyperfréquences, soit du signal utile amplifié, soit du signal de test, soit les deux.

La figure 3 montre un synoptique d'une fonction à réaliser par la structure de commutation selon l'invention comportant un commutateur/inverseur COM en série avec un amplificateur AMP. Deux modes de fonctionnement sont prévus, un mode « mode normal »mn et un « mode test » mt.

Dans le mode de fonctionnement normal le commutateur COM de la figure 3 est en position mn telle que l'amplificateur reçoit le signal venant de l'antenne A et le délivre amplifié à sa sortie S. Dans un fonctionnement en « mode test » le commutateur/inverseur COM est commandé en position test mt et un signal de test St, venant du système, est appliquée à l'entrée de l'amplificateur et est délivré amplifié à sa sortie S.

Deux solutions alternatives, utilisant des structures distribuées, sont alors possibles.

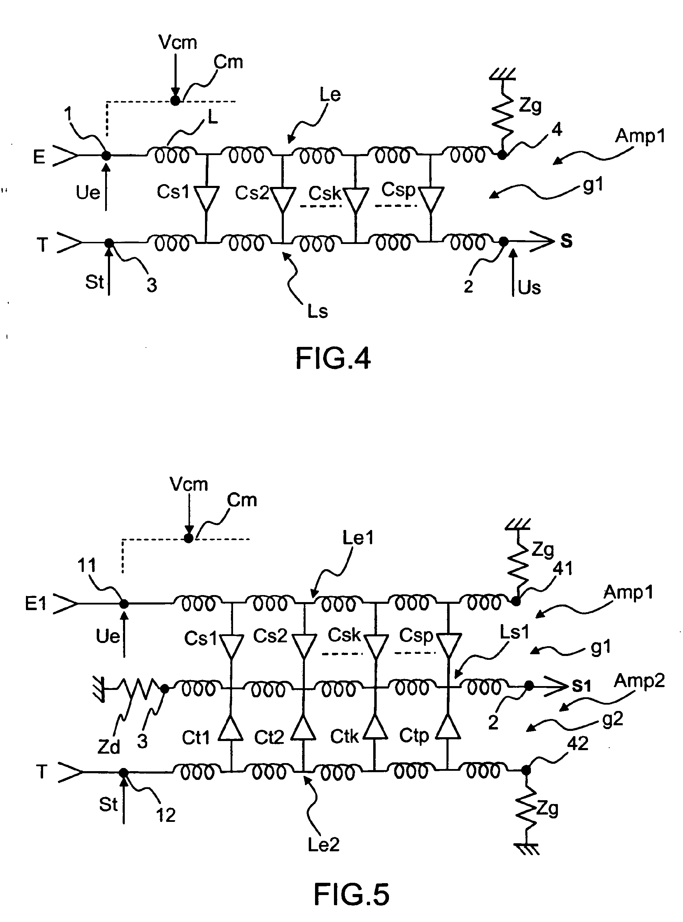

La figure 4 montre une première structure de commutation à amplificateur distribué selon l'invention comportant une entrée T de test.

La structure de commutation de la figure 4 comporte un amplificateur distribué Amp1 (n=1) pour former deux voies de signal (q=2), une voie de signal amplificatrice pour un signal utile Ue (signal d'entrée) et, une voie non amplificatrice (voie passive) pour un signal de test St.

La structure de commutation de la figure 4 comporte la structure de base à amplificateur distribué de la figure 2a sans l'impédance de charge Zd de la ligne de sortie Ls. Les éléments passifs d'entrée pe1, pe2, ...pek, ...pep, pour la ligne d'entrée Le et ps1, ps2, ...psk, ...psp, pour la ligne de sortie Ls sont par exemple dans les réalisations des selfs de même valeur L.

L'amplificateur distribué Amp1 de la figure 4 comporte une entrée de commande Cm des cellules amplificatrices actives Cs1, Cs2,...Csk,...Csp. pour les mettre simultanément, soit dans un état amplificateur, soit dans un état bloqué.

Dans l'état amplificateur, les cellules amplificatrices actives amplifient le signal utile Ue applique à l'accès 1 d'entrée de la ligne d'entrée Le fournissant un signal Us à l'accès 2 de sortie de la ligne de sortie Ls qui est aussi la sortie S de la structure.

Dans l'état bloqué, les cellules amplificatrices atténuent fortement le signal utile Ue. La tension de sortie Us à la sortie S de la structure devient par conséquent très faible.

Les deux modes (normal mn ou test mt) de la structure de commutation sont commutés par un signal de commande Vcm qui vient s'appliquer sur les tensions de polarisation des éléments actifs des cellules amplificatrices représentés par des triangles. Ce signal de commande Vcm peut prendre plusieurs formes : par exemple, si les éléments actifs sont constitués de transistors à effet de champ, la tension de commande Vcm peut être appliquée soit sur la grille du transistor (ou d'un des transistors d'un montage combinant plusieurs transistors) soit sur le drain.

En « mode normal » mn, les éléments actifs des cellules amplificatrices sont commandés pour être amplificateurs, aucun signal test St n'est appliqué sur l'accès d'entrée 3 de la ligne de sortie Ls. Le signal utile Ue est amplifié par l'amplificateur distribué qui fournit à sa sortie S un signal utile Ue amplifié, soit une tension de sortie Us.

En « mode test » mt, dans une première phase, les éléments actifs des cellules amplificatrices sont bloqués par le signal de commande Vcm, isolant la sortie S de l'amplificateur distribué de tout signal parasite pouvant venir de l'antenne (entrée E) connectée à l'accès d'entrée 1 de la ligne d'entrée Le, puis dans une deuxième phase, le signal de test St, généré par le système, est alors appliqué sur l'accès d'entrée 3 de la ligne de sortie Ls (entrée T) qui se propage, sans amplification (voie passive), vers la sortie S de l'amplificateur distribué, à travers la ligne de sortie Ls de la structure de commutation.

Le signal de test St permet de tester ou calibrer toutes les parties d'un système de réception/émission venant en aval, à partir de la sortie S du dispositif à amplificateur distribué. La différence avec la structure dite « classique » de la Figure 3 est que le signal de test St n'est pas amplifié, il ne permet donc pas de tester la partie amplificatrice du dispositif.

Dans la structure dite « classique », le signal de test St ne permettait pas de tester la voie « signal » du commutateur/inverseur. En fait, le signal de test ne peut, par construction, tester le premier dispositif rencontré par le signal nominal.

Dans la structure selon l'invention permettant de supprimer le commutateur/inverseur COM, le premier dispositif, non testable, est l'amplificateur de tête. Il est par contre possible de tester tout le système en aval, ce qui est généralement suffisant dans la pratique.

Dans le cas où l'on désire une plus grande symétrie de traitement entre le signal utile Ue provenant de l'antenne et le signal de test St, on peut utiliser une structure de commutation distribuée double pour former deux voies de signal amplificatrices (q=2), une voie pour le signal utile Ue et une voie pour le signal de test St.

La figure 5 montre une structure de commutation selon l'invention à double amplificateur distribué comportant deux amplificateurs distribués Amp1, Amp2, une entrée E1 de signal utile Ue et une entrée de test T pour un signal de test St.

Dans la réalisation de la figure 5 la structure double comporte une première ligne d'entrée Le1 d'un premier amplificateur distribué Amp1, une deuxième ligne d'entrée Le2 d'un deuxième amplificateur distribué Amp2, et une ligne de sortie commune Ls1 aux deux amplificateurs distribués chargée par son accès d'entrée de signal 3 par une impédance de charge adaptée Zd.

La première ligne d'entrée Le1 forme avec un premier groupe g1 de cellules amplificatrices Cs1, Cs2, ...Csi, ...Csp, et la ligne de sortie commune Ls1 le premier amplificateur distribué Amp1 destiné à amplifier le signal utile Ue appliqué à l'accès d'entrée 1 de la première ligne d'entrée Le1 soit à l'entrée E1 de la structure.

La deuxième ligne d'entrée Le2 forme avec un deuxième groupe g2 de cellules amplificatrices Ct1, Ct2, ...Cti, ...Ctp, et la ligne de sortie commune Ls1 le deuxième Amp2 amplificateur distribué, symétrique du premier Amp1, destiné à amplifier le signal de test St appliqué à l'accès d'entrée 12 de la deuxième ligne d'entrée Le2, soit à l'entrée T de test de la structure.

La structure de commutation de la figure 5 forme un commutateur ou combineur actif,

Un signal de commande Vcm assure une commande du premier g1 et du deuxième g2 groupes de cellules amplificatrices du premier Amp1 et du deuxième Amp2 respectifs amplificateurs distribués.

Le signal de commande Vcm peut par exemple prendre deux niveaux correspondant à deux états de la structure amplificatrice double de commutation.

Dans un premier état, la structure double de commutation est mise en mode amplificateur du signal utile Ue appliqué par l'antenne à l'entrée E1 (accès 11) de la première ligne d'entrée Ls1 par la polarisation des cellules amplificatrices Cs1, Cs2, ...Csi, ...Csp, du premier groupe g1 et simultanément par le blocage des cellules amplificatrices Ct1, Ct2, ...Cti, ...Ctp, du deuxième groupe g2. Dans ce premier état, le signal utile Ue à l'entrée E1 est amplifié par le premier groupe g1 de cellules amplificatrices et se retrouve amplifié (tension Us) en sortie S1 de la structure ou à l'accès de sortie 2 de la ligne de sortie commune Ls1.

Dans un second état, la structure double de commutation, est mise en mode test par exemple, par l'inversion du signal de commande Vcm appliqué aux cellules amplificatrices des deux groupes produisant le blocage les éléments actifs du premier groupe de cellules amplificatrices Cs1, Cs2, ...Csi, ...Csp, et simultanément la polarisation des éléments actifs du deuxième groupe de cellules amplificatrices Ct1, Ct2, ...Cti, ...Ctp, du signal de test.

Dans le mode test, le signal de test St est appliqué à l'entrée T de la structure soit à l'accès d'entrée 12 de la deuxième ligne d'entrée Le2 qui se trouve amplifié par le deuxième groupe de cellules amplificatrices en sortie S1 de la structure, soit à l'accès de sortie 2 de la ligne commune de sortie Ls1.

L'avantage de cette structure double de commutation à amplificateurs distribués par rapport à la précédente représentée à la figure 4 est de permettre, moyennant le fait de symétriser la structure par rapport à la ligne commune de sortie Ls1, de tester un dispositif équivalent au premier dispositif rencontré par le signal (seule l'antenne n'est pas testée).

La structure de commutation double à amplificateurs distribués de la figure 5 peut être facilement adaptée pour amplifier deux signaux utiles Ue1, Ue2 différents, chacun provenant d'une antenne et un signal de test St, la structure comportant deux entrées de signaux d'antenne E1, E2, une entrée de signal de test T et une sortie de signal S1.

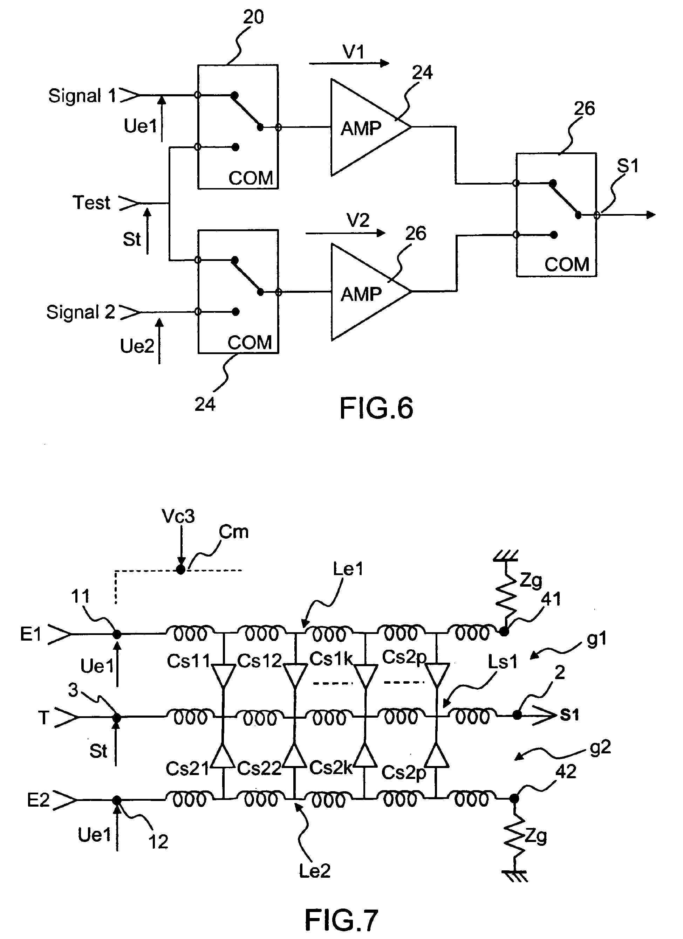

La figure 6 montre un synoptique d'une autre fonction à réaliser par la structure de commutation selon l'invention comportant deux commutateur/inverseur COM 20, 22 en entrée en série avec un respectif amplificateur AMP 24, 26 formant deux voies d'amplification V1, V2 soit de l'un Ue1 et de l'autre Ue2 signaux d'entrée, soit du signal de test St et, un autre commutateur/inverseur 28 pour le choix soit de l'une V1 ou de l'autre V2 voies d'amplification.

Il est cependant tout à fait envisageable d'étendre les principes énoncés à un nombre supérieur de signaux. Dans le cas de 2 signaux, la fonction à réaliser est traditionnellement réalisée selon le schéma de la Figure 1, avec N=2. Le dispositif possède donc 3 entrées (« Signal 1 », « Signal 2 » et « Test »). Selon les besoins du système le dispositif d'injection de signal de test pourra comporter une ou deux sorties.

La figure 7 montre une variante de la structure de commutation double à amplificateurs distribués de la figure 5 pour former trois voies de signal (q=3), une première voie amplificatrice pour un premier signal utile Ue1, une deuxième voie amplificatrice pour un deuxième signal utile Ue2 et une troisième voie passive pour le signal de test St.

La structure de la figure 7 comporte deux entrées E1, E2 de respectif signal utile Ue1, Ue2, l'entrée T de signal de test St et la sortie de signal S1.

La structure de commutation à double signal Ue1, Ue2 de la figure 7 est très proche de celle de la figure 5.

L'accès d'entrée 3 de la ligne commune de sortie Ls du côté des accès d'entrée 11, 12 des lignes d'entrés Le1, Le2 est utilisé, dans cette réalisation, pour appliquer le signal de test St à la structure à double signal. Les accès 11, 12 des deux lignes d'entrée respectives Le1, Le2 formant les entrées E1 et E2 de la structure reçoivent l'une 11 un premier signal utile Ue1 et l'autre un deuxième signal utile Ue2, par exemple, provenant d'une respective antenne A1, A2.

Un signal de commande Vc3 peut, par exemple, prendre trois niveaux différents correspondant à trois états de la structure amplificatrice double par exemple les niveaux 1, 0,-1.

Dans un premier état, la structure de commutation à double signal est mise dans un mode amplificateur du premier signal utile Ue1 appliqué par l'antenne A1 à l'accès d'entrée 11 de la première ligne d'entrée Ls1 par la polarisation des éléments actifs du premier groupe g1 de cellules amplificatrices Cs11, Cs12, ...Cs1i, ...Cs1p, et simultanément par le blocage des éléments actifs du deuxième groupe g2 de cellules amplificatrices Cs21, Cs22, ...Cs2i, ...Cs2p, du deuxième signal utile Ue2.

Dans un deuxième état la structure de commutation à double signal est mise dans un mode amplificateur du deuxième signal utile Ue2 appliqué par l'antenne A2 à l'accès d'entrée 12 de la deuxième ligne d'entrée Ls2 par la polarisation des éléments actifs du premier groupe g1 de cellules amplificatrices Cs11, Cs12, ...Cs1i, ...Cs1 p, et simultanément le blocage des éléments actifs du deuxième groupe g2 de cellules amplificatrices Cs21, Cs22, ...Cs2i, ...Cs2p, du deuxième signal utile Ue2.

Dans un troisième état, la structure de commutation à double signal est mise dans un mode test en bloquant les éléments actifs du premier g1 et du deuxième g2 groupes de cellules amplificatrices et en appliquant le signal de test St à l'accès d'entrée 3 de la ligne commune de sortie Ls. Aucun des deux signaux utiles Ue1, Ue2 ne sont transmis en sortie S1 de la structure à double signal.

Dans ce troisième état le signal de test Ts est transmis sans amplification à l'accès de sortie 2 de la ligne commune de sortie Ls, soit à la sortie S1 de la structure.

On peut ainsi commuter entre les signaux présentés sur les trois entrées (sans pouvoir bloquer un signal présent sur la voie « test », ce qui n'est pas gênant à partie du moment où un tel signal St est généré par le système et peut donc être inhibé à sa source).

La structure de commutation à double signal peut être mise dans un quatrième état correspondant à la polarisation des premier et deuxième groupes de cellules amplificatrices. Tous les cellules amplificatrices étant polarisées en amplificateur, nous obtenons la combinaison active en sortie S1 (sommation avec gain) des signaux utiles Ue1 et Ue2 appliqués aux deux accès d'entrée 11, 12 des lignes d'entrée Le1, Le2 de la structure.

Dans certaines applications multivoies de réception, les différents signaux d'antenne Ue1, Ue2, Ue1, ... UeN, doivent être traités simultanément et séparément, il faut que le dispositif comporte autant de sorties que de signaux d'antenne. Dans le cas d'un dispositif à 2 signaux Ue1, Ue2, il faut donc 3 entrées et 2 sorties.

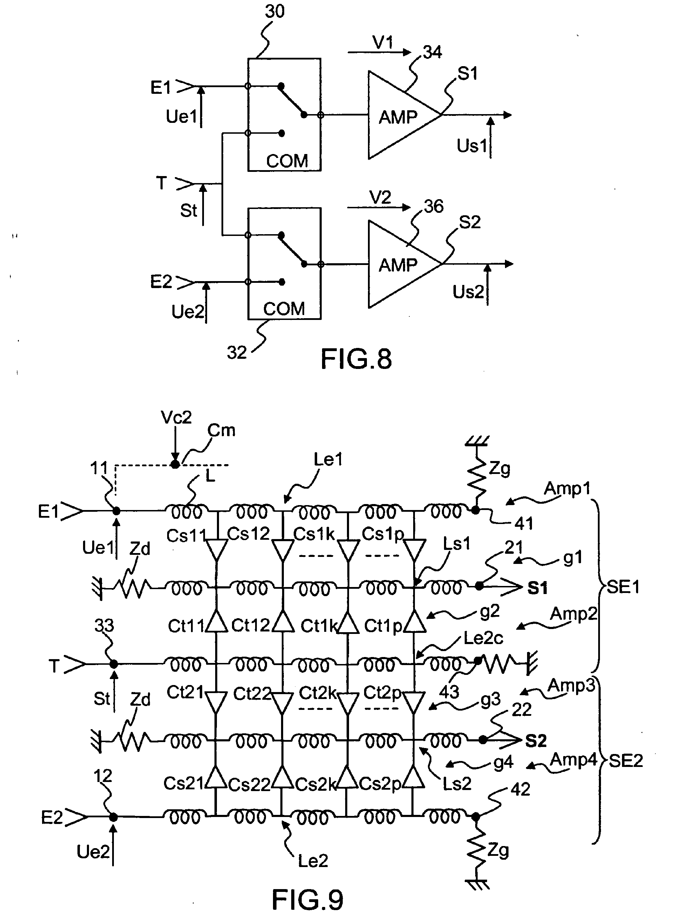

La figure 8 montre un synoptique d'une autre fonction électronique comportant une structure de commutation à double signal selon l'invention comportant deux entrées E1, E2 et deux sorties S1, S2 de signaux et une entrée T de signal de test St.

Pour réaliser la fonction de la figure 8 il faut deux commutateurs/inverseurs COM 30, 32 chacun en série avec un respectif amplificateur AMP 34, 36 formant deux voies d'amplification V1, V2 séparées. L'un 30 et l'autre 32 commutateur/inverseur permettent de choisir une amplification de l'un Ue1, de l'autre Ue2 signaux d'entrée ou du signal de test St.

Il est possible d'étendre le principe de commutation active à large bande à amplificateur distribué à un dispositif plus complexe, comportant trois lignes d'entrée (lignes de grille) et deux lignes de sortie (lignes de drain).

La figure 9 montre une structure électronique hyperfréquences de commutation selon l'invention à amplificateurs distribués à double signal pour former quatre voies de signal amplificatrices (q=4), deux voies amplificatrices chacune amplifiant un respectif signal utile (ou d'entrée) Ue1, Ue2 et deux autres voies amplificatrices pour le signal de test St.

La structure de la figure 9 comporte deux entrées E1, E2 de signal, deux sorties S1, S2 de signal amplifié et une entrée T de signal de test St.

La structure de la figure 9 comporte, outre le premier Amp1 et le deuxième Amp2 amplificateurs distribués de la figure 5 formant un premier sous-ensemble SE1 à amplificateurs distribués comportant la sortie de signal hyperfréquences S1, un troisième Amp3 et un quatrième Amp4 amplificateurs distribués formant un deuxième sous-ensemble SE2 à amplificateurs distribués symétrique du premier par rapport à la deuxième ligne d'entrée commune Le2c aux deux sous-ensembles SE&, SE2 (la ligne d'entrée commune Le2c est repérée Le2 dans la réalisation de la figure 5).

Les troisième et quatrième amplificateurs distribués comportant respectivement un troisième g3 et quatrième g4 groupes de cellules amplificatrices, le deuxième sous-ensemble SE2 comportant une autre sortie de signal hyperfréquences S2

Comme dans la structure de la figure 5, le premier sous-ensemble ES1 comporte la première ligne d'entrée Le1 formant avec le premier groupe g1 de cellules amplificatrices Cs11, Cs12, ...Cs1i, ...Cs1p, et la ligne de sortie commune Ls1 le premier amplificateur distribué Amp1 destiné à amplifier le premier signal utile Ue1 appliqué à l'accès d'entrée 11 de la première ligne d'entrée Le1.

La deuxième ligne d'entrée commune Le2c du premier sous-ensemble ES1 forme avec le deuxième groupe g2 de cellules amplificatrices Ct11, Ct12, ...Ct1i, ...Ct1 p, symétrique du premier groupe, et la ligne commune de sortie Ls1 du premier sous-ensemble SE1, le deuxième amplificateur distribué Amp2 destiné à amplifier le signal de test appliqué à l'accès d'entrée 33 de la deuxième ligne commune d'entrée Le2c de la structure.

Le deuxième sous-ensemble ES2 symétrique du premier comporte une autre première ligne d'entrée Le2 formant avec le quatrième groupe g4 de cellules amplificatrices Cs21, Cs22, ...Cs2i, ...Cs2p et une autre ligne commune de sortie Ls2 du deuxième sous-ensemble ES2 le quatrième amplificateur Amp4 distribué destiné à amplifier, par le deuxième sous-ensemble ES2, un autre signal utile Ue2 appliqué à l'accès d'entrée 12 de l'autre première ligne d'entrée Le2.

La deuxième ligne d'entrée commune Le2c de la structure forme avec le troisième groupe g3 de cellules amplificatrices Ct21, Ct22, ...Ct2i, ...Ct2p, symétrique du deuxième groupe g2 et l'autre ligne commune de sortie Ls2 le troisième amplificateur Amp3 distribué destiné à amplifier, par le deuxième sous-ensemble ES2, le signal de test appliqué à l'entrée 33 de la deuxième ligne d'entrée commune Le2c.

Un signal de commande Vc2 peut prendre deux niveaux différents par exemple 0,1 pour mettre la structure de la figure 9, soit dans un état dit normal dans lequel les deux tensions Ue1 et Ue2 sont amplifiées par les cellules amplificatrices, soit sans un état dit de test amplifiant le signal de test appliquée à l'entrée de test T.

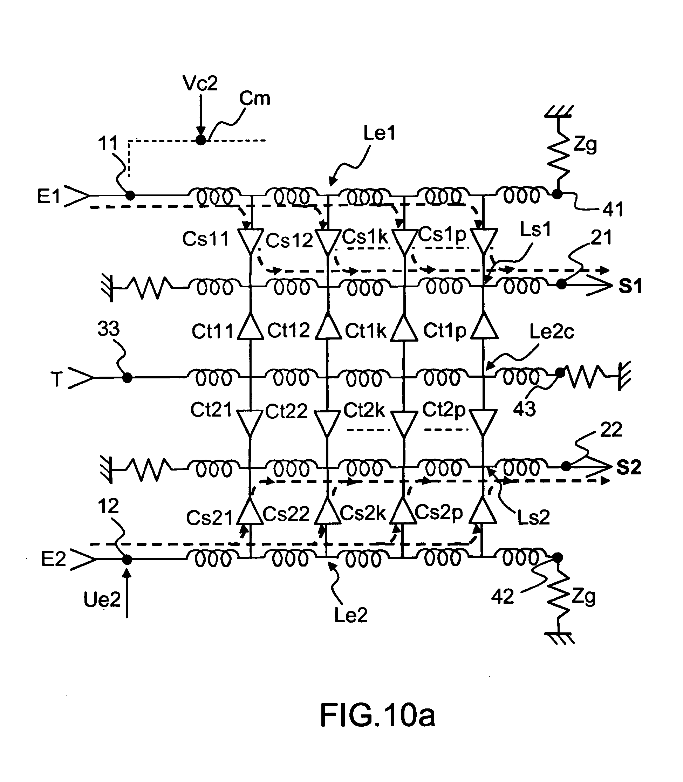

La figure 10a montre le fonctionnement dit normal de la structure de commutation de la figure 9. La figure 10a montre le fonctionnement dit de test de la structure de commutation de la figure 9.

Dans le mode de fonctionnement normal de la structure de commutation de la figure 9, le premier groupe g1 de cellules amplificatrices Cs11, Cs12, ...Cs1i, ...Cs1p, du premier sous-ensemble ES1 et le quatrième groupe g4 de cellules amplificatrices Cs21, Cs22, ...Cs2i, ...Cs2p, de l'autre sous-ensemble ES2 symétrique du premier sont polarisée par le signal de commande Vc2 pour être amplificatrices. Les deux autres groupes g2, g3 de cellules amplificatrices sont bloqués.

Le dispositif multifonction de la figure 9 se comporte comme un ensemble de deux amplificateurs Amp1, Amp4 distribuées séparés et symétriques pour l'un Ue1 et l'autre Ue2 signaux appliqués aux entrées de signal E1, E2 de la structure. Chacun des amplificateurs distribués comporte l'entrée E1, E2 respective et la sortie S1, S2 respective, indépendantes les unes des autres.

Le fonctionnement de chaque amplificateur distribué amplifiant les signaux utiles Ue1 et Ue2 est très peu perturbé par la présence du circuit dédié à l'injection du signal de test.

Les signaux utiles Ue1, Ue2 venant des antennes sont amplifiés, sans rencontrer d'élément passif, avant l'étage amplificateur, susceptible de dégrader le facteur de bruit du récepteur comme le commutateur/inverseur COM de la structure traditionnelle.

La figure 10a montre en trait pointillé le parcours des deux signaux utiles Ue1 et Ue2 dans les différents éléments de la structure de commutation double de la figure 9 dans le mode dit normal.

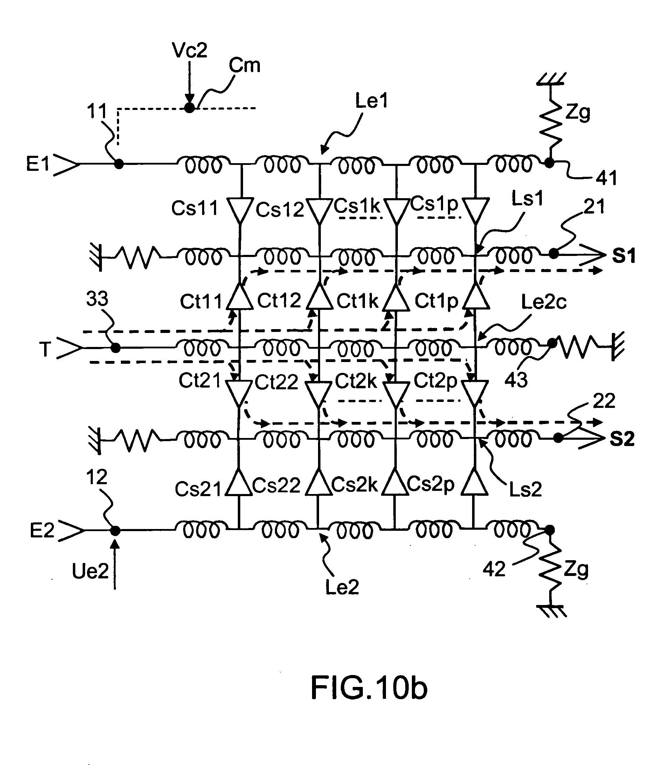

La figure 10b montre le fonctionnement dit de test de la structure de commutation de la figure 9.

Dans le mode de fonctionnement dit de test de la structure de commutation de la figure 9, le deuxième groupe de cellules amplificatrices Ct11, Ct12, ...Ct1i, ...Ct1p, du premier sous-ensemble ES1 et le troisième groupe g3 de cellules amplificatrices Ct21, Ct22, ...Ct2i, ...Ct2p, du deuxième sous-ensemble ES2 symétrique du premier sont polarisés par la tension de commande Vc2 pour être amplificateurs. Les deux autres groupes g1, g4 de cellules amplificatrices sont bloqués et se présentent en première approximation comme des circuits ouverts.

La structure électronique hyperfréquences de commutation de la figure 9 dans l'état dit de test se comporte alors comme un amplificateur distribué à double ligne de sortie, ayant la fonction de diviseur actif.

Le signal de test St injecté sur la deuxième ligne d'entrée commune Le2c se partage, avec amplification, sur l'une Ls1 et l'autre Ls2 lignes de sortie des deux sous-ensembles ES1, ES2 symétriques et se trouve disponible de manière symétrique sur les deux sorties S1, S2 de la structure pour tester et calibrer le système.

Il faut noter que le dessin de la structure de commutation de la figure 9 est symétrique et que cette symétrie est généralement très bien respectée au sens du fonctionnement électrique. En effet, dans sa réalisation préférentielle sous forme de circuit intégré monolithique (MMIC), le circuit final est de taille réduite et les caractéristiques des éléments (actifs et passifs) sont très reproductibles sur sa surface.

Les figures décrites montrent des réalisations des structures hyperfréquences comportant plusieurs amplificateurs distribués, certains amplificateurs distribués consécutifs dans la suite d'amplificateurs de 1 à n ont une ligne de sortie Ls commune (Ls1, Ls2). Ces réalisations ne sont pas limitatives et des structures hyperfréquences selon l'invention peuvent comporter plus de deux amplificateurs distribués connectés sur une même ligne de sortie Ls commune.

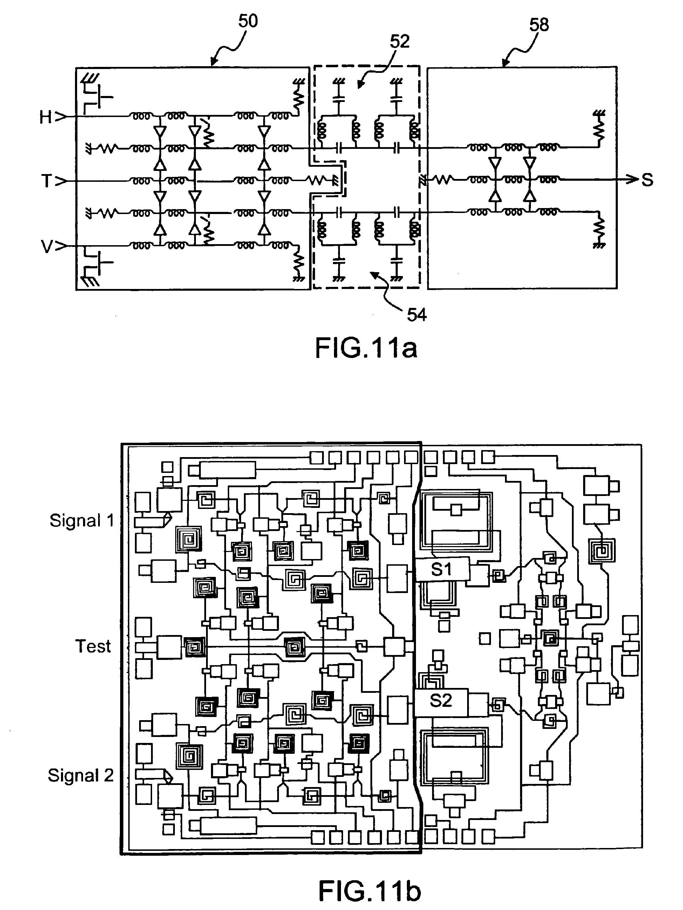

La figure 11a montre un exemple de réalisation d'un circuit multifonction comportant une structure électronique hyperfréquences de commutation représentée à la figure 9.

Le circuit multifonctions de la figure 11a comporte une structure électronique hyperfréquences de commutation 50 selon l'invention tel que représentée à la figure 9. Les sorties indépendantes S1, S2 de la structure de commutation 50 attaquent des entrées respectives d'un premier 52 et un second déphaseur 54 90° dont les sorties attaquent les entrées d'un sommateur 58 à amplificateur distribué tel que représenté à la figure 5.

La figure 11b montre à titre d'exemple le dessin du masque du circuit multifonction de la figure 11 a.

La partie du masque correspondant à la structure de commutation selon l'invention est encadrée en trait gras.

## Revendications

1. Structure électronique hyperfréquences de commutation comportant au moins une entrée de signal utile (E, E1, E2, Ex) destinée à recevoir un signal utile (Ue, Ue1, Ue2), une entrée de signal de test (T) destinée à recevoir un signal de test (St), au moins une sortie de signal hyperfréquences (S, S1, S2),
**caractérisé en ce qu'**elle comporte n amplificateurs (Amp1, Amp2, ...Ampi, ...Ampn) distribués, n étant supérieur ou égal à 1, pour former q voies de signal, q étant supérieur ou égal à 2, chaque amplificateur distribué comportant un groupe (g1, g2,...gi,...gn) de cellules amplificatrices (Cs1, Cs2,..Csk,...Csp) distribuées entre une ligne d'entrée (Le, Le1, Le2, Le2c) et une ligne de sortie (Ls, Ls1, Ls2),
la ligne d'entrée ayant à une des ses extrémités un accès d'entrée de signal hyperfréquences (1, 11, 12) et, à l'autre extrémité (4, 41, 42, 43), un accès de charge,
la ligne de sortie ayant à une de ses extrémités, du côté de l'accès de charge de la ligne d'entrée, un accès de sortie de signal hyperfréquences (2, 21, 22) et à l'autre extrémité, un accès d'entrée (3, 31) de signal hyperfréquences,
l'accès d'entrée (1, 11, 12) de signal hyperfréquences d'au moins d'une des lignes d'entrée (Le, Le1, Le2) d'un amplificateur distribué étant l'entrée (E, E1, E2) de signal utile (Ue, Ue1, Ue2), l'accès d'entrée de signal hyperfréquences d'une autre des lignes étant l'entrée (T) de signal de test (St), l'accès de sortie de signal hyperfréquences d'au moins une des lignes de sortie (Ls, Ls1, Ls2) étant la sortie (S, S1, S2) de signal hyperfréquences,
chacune des cellules amplificatrices (Cs1, Cs2, ...Csk, ...Csp) comportant une entrée de commande Cd pour mettre lesdites cellules amplificatrices d'un groupe (g1, g2, ...gi, ...gn) indépendamment d'un autre groupe, soit dans un état amplificateur, soit dans un état bloqué, pour effectuer une transmission à la sortie de signal hyperfréquences (S, S1, S2), soit du signal utile (Ue, Ue1, Ue2) amplifié, soit du signal de test (St),
une unité de commande UC pour commander les cellules amplificatrices de chacun des groupes, soit dans l'état amplificateur, soit dans l'état bloqué.

2. Structure électronique hyperfréquences de commutation selon la revendication 1, **caractérisée en ce qu'**elle comporte un seul amplificateur distribué (n=1) pour former deux voies de signal (q=2), une voie de signal amplificatrice pour le signal utile (Ue) et, une voie non amplificatrice (voie passive) pour un signal de test St, l'accès d'entrée (3) de signal hyperfréquences de la ligne de sortie Ls étant l'entrée de signal de test (T), l'accès de sortie (2) de signal hyperfréquences de la ligne de sortie Ls étant la sortie (S) de signal hyperfréquences fournissant, soit le signal utile (Ue) amplifié par l'amplificateur distribue (Amp1) lorsque les cellules amplificatrices dudit amplificateur distribué sont mises dans l'état amplificateur, soit le signal de test (St) transmis par la ligne de sortie (Ls) lorsque lesdites cellules amplificatrices sont mises dans l'état bloqué et que le signal de test (St) est appliqué à l'entrée de signal de test (T) de ladite ligne de sortie (Ls).

3. Structure électronique hyperfréquences de commutation selon la revendication 1, **caractérisée en ce qu'**elle comporte un premier (Amp1) et un deuxième (Amp2) amplificateurs distribués symétriques par rapport à une ligne de sortie (Ls1) commune pour former deux voies de signal amplificatrices (q=2), une voie pour le signal utile (Ue) et une voie pour le signal de test (St), les amplificateurs distribués ayant respectivement, un premier (g1) et un deuxième (g2) groupes de cellules amplificatrices, une première (Le1) et une deuxième (Le2) lignes d'entrée,
l'accès (3) d'entrée de signal hyperfréquences de la ligne de sortie commune (Ls1) étant connectée à une charge de ligne de sortie (Zd), l'accès de sortie (2) de signal hyperfréquences de la ligne de sortie (Ls1) étant la sortie (S1) de signal hyperfréquences,
l'entrée (E1) de signal utile (Ue) étant l'accès d'entrée (11) de la première ligne d'entrée (Le1) formant avec le premier groupe (g1) de cellules amplificatrices et la ligne de sortie commune (Ls1) le premier amplificateur distribuée (Amp1) du signal utile (Ue),
l'entrée (T) de signal test (St) étant l'accès d'entrée (12) de la deuxième ligne d'entrée (Le2) formant avec le deuxième groupe (g2) de cellules amplificatrices et la ligne de sortie commune (Ls) le deuxième (Amp2) amplificateur distribuée du signal de test (St),
la sortie (S1) de signal hyperfréquences fournissant, soit le signal utile (Ue) amplifié lorsque les cellules amplificatrices du premier groupe (g1) sont mises dans l'état amplificateur et celles du deuxième (g2) groupe dans l'état bloqué, soit le signal de test (St) lorsque les cellules amplificatrices du premier groupe sont mises dans l'état bloqué et celles du deuxième groupe dans l'état amplificateur et que le signal de test (St) est appliqué à l'accès d'entrée (12) de la deuxième ligne d'entrée (Le2).

4. Structure électronique hyperfréquences de commutation selon la revendication 1, **caractérisée en ce qu'**elle comporte un premier (Amp1) et un deuxième (Amp2) amplificateurs distribués symétriques par rapport à une ligne de sortie (Ls1) commune pour former trois voies de signal (q=3), une première voie amplificatrice pour un premier signal utile (Ue1), une deuxième voie amplificatrice pour un deuxième signal utile (Ue2) et une troisième voie passive pour le signal de test (St), les amplificateurs distribués ayant respectivement un premier (g1) et un second (g2) groupes de cellules amplificatrices, une première (Le1) et une deuxième (Le2) lignes d'entrée,
l'accès (3) d'entrée de signal hyperfréquences de la ligne de sortie commune (Ls1) étant l'entrée (T) de signal de test (St), l'accès de sortie (2) de signal hyperfréquences de la ligne de sortie commune (Ls1) étant la sortie (S1) de signal hyperfréquences,
l'entrée (E1) d'un premier signal utile (Ue1) étant l'accès d'entrée (11) de la première ligne d'entrée (Le1) formant avec le premier groupe (g1) de cellules amplificatrices et la ligne de sortie commune (Ls1) le premier amplificateur (Amp1) distribuée du premier signal utile (Ue1),
l'entrée (E2) d'un deuxième signal utile (Ue2) étant l'accès d'entrée (12) de la deuxième ligne d'entrée (Le2) formant avec le deuxième groupe (g2) de cellules amplificatrices et la ligne de sortie commune (Ls1) le deuxième amplificateur (Amp2) distribuée du deuxième signal utile (Ue2),
la sortie hyperfréquences (S1) fournissant, soit le premier signal utile (Ue1) amplifié lorsque les cellules amplificatrices du premier groupe (g1) sont mises dans l'état amplificateur et celles du deuxième groupe (g2) dans l'état bloqué, soit le deuxième signal utile (Ue2) amplifié lorsque les cellules amplificatrices du premier groupe (g1) sont mises dans l'état bloqué et celles du deuxième groupe (g2) dans l'état amplificateur, soit le signal de test (St) lorsque les cellules amplificatrices du premier et du deuxième groupes sont mises dans l'état bloqué et que le signal de test (St) est appliqué à l'accès (3) d'entrée de signal de la ligne de sortie (Ls1) commune.

5. Structure électronique hyperfréquences de commutation selon la revendication 3, **caractérisée en ce qu'**elle comporte, outre le premier (Amp1) et le deuxième (Amp2) amplificateurs distribués formant un premier sous-ensemble (SE1) à amplificateurs distribués comportant la sortie de signal hyperfréquences (S1), un troisième (Amp3) et un quatrième (Amp4) amplificateurs distribués formant un deuxième sous-ensemble (SE2) à amplificateurs distribués symétrique du premier par rapport à la deuxième ligne d'entrée commune (Le2c) aux deux sous ensembles (SE1, SE2), pour former quatre voies de signal amplificatrices (q=4), deux voies amplificatrices chacune amplifiant un respectif signal utile (Ue1, Ue2) et deux autres voies amplificatrices pour le signal de test (St), les troisième et quatrième amplificateurs distribués comportant respectivement un troisième (g3) et quatrième (g4) groupes de cellules amplificatrices, le deuxième sous-ensemble (SE2) comportant une autre sortie de signal hyperfréquences (S2)
les deux sous-ensembles symétriques (ES1, ES2) ayant, la deuxième ligne d'entrée commune (Le2c), l'accès d'entrée (33) de la deuxième ligne d'entrée commune (Le2c) étant l'entrée de signal de test (T),
l'autre sortie hyperfréquences (S2) du deuxième sous-ensemble (ES2) fournissant:
soit un autre signal utile (Ue2) amplifié appliqué à une autre entrée (E2) de la première ligne d'entrée (Le1) du deuxième sous-ensemble (ES2), lorsque les cellules amplificatrices du quatrième (g4) groupe de cellules amplificatrices du deuxième sous-ensemble (ES2) sont mises dans l'état amplificateur et celles du troisième groupe (g3) de ce deuxième sous-ensemble (ES2) dans l'état bloqué,
soit le signal de test (St) lorsque les cellules amplificatrices du troisième groupe (g3) de cellules amplificatrices du deuxième sous-ensemble (ES2) sont mises dans l'état amplificateur et celles du quatrième groupe (g4) groupe de ce deuxième sous-ensemble (ES2) dans l'état bloqué et que le signal de test (St) est appliqué l'accès d'entrée (33) de la deuxième ligne d'entrée commune (Le2c).

6. Structure électronique hyperfréquences de commutation selon l'une des revendications 1 à 5, **caractérisée en ce que** les accès (4, 41, 42, 43) de charge des lignes d'entrée (Le, Le1, Le2, Le2c) sont connectés à une impédance (Zg) caractéristique desdites lignes d'entrée.

## Patentansprüche

1. Elektronische Ultrahochfrequenz-Schaltstruktur, die wenigstens einen Nutzsignaleingang (E, E1, E2, Ex) zum Empfangen eines Nutzsignals (Ue, Ue1, Ue2), einen Testsignaleingang (T) zum Empfangen eines Testsignals (St) und wenigstens einen Ultrahochfrequenzsignal-Ausgang (S, S1, S2) umfasst,
**dadurch gekennzeichnet, dass** sie n verteilte Verstärker (Amp1, Amp2,...Ampi,...Ampn) umfasst, wobei n gleich oder größer als 1 ist, zum Bilden von q Signalkanälen, wobei q gleich oder größer als 2 ist, wobei jeder verteilte Verstärker eine Gruppe (g1, g2,...gi,...gn) von Verstärkungszellen (Cs1, Cs2,..Csk,...Csp) umfasst, die zwischen einer Eingangsleitung (Le, Le1, Le2, Le2c) und einer Ausgangsleitung (Ls, Ls1, Ls2) verteilt sind,
wobei die Eingangsleitung an einem Ende einen Ultrahochfrequenzsignal-Eingangsanschluss (1, 11, 12) und am anderen Ende einen Lastanschluss (4, 41, 42, 43) aufweist,
wobei die Ausgangsleitung an einem Ende auf der Lastanschlussseite der Eingangsleitung einen Ultrahochfrequenzsignal-Ausgangsanschluss (2, 21, 22) und am anderen Ende einen Ultrahochfrequenzsignal-Eingangsanschluss (3, 31) aufweist,
wobei der Ultrahochfrequenzsignal-Eingangsanschluss (1, 11, 12) von wenigstens einer der Eingangsleitungen (Le, Le1, Le2) eines verteilten Verstärkers der Nutzsignal-(Ue, Ue1, Ue2)-Eingang (E, E1, E2) ist, wobei der Ultrahochfrequenzsignal-Eingangsanschluss einer anderen der Leitungen der Testsignal-(St)-Eingang (T) ist, wobei der Ultrahochfrequenzsignal-Ausgangsanschluss von wenigstens einer der Ausgangsleitungen (Ls, Ls1, Ls2) der Ultrahochfrequenzsignal-Ausgang (S, S1, S2) ist,
wobei jede der Verstärkungszellen (Cs1, Cs2,..Csk,...Csp) einen Steuereingang Cd umfasst, um die Verstärkungszellen einer Gruppe (g1, g2,...gi,...gn) unabhängig von einer anderen Gruppe entweder in einen Verstärkungszustand oder in einen gesperrten Zustand zu setzen, um am Ultrahochfrequenzsignal-Ausgang (S, S1, S2) eine Übertragung entweder des verstärkten Nutzsignals (Ue, Ue1, Ue2) oder des Testsignals (St) zu bewirken,
eine Steuereinheit UC, um die Verstärkungszellen jeder der Gruppen entweder in den verstärkten Zustand oder in den gesperrten Zustand zu steuern.

2. Ultrahochfrequenz-Schaltstruktur nach Anspruch 1, **dadurch gekennzeichnet, dass** sie einen einzigen verteilten Verstärker (n=1) zum Bilden von zwei Signalkanälen (q=2), einen Verstärkungssignalkanal für das Nutzsignal (Ue) und einen nicht verstärkenden Kanal (passiver Kanal) für ein Testsignal St umfasst, wobei der Ultrahochfrequenzsignal-Eingangsanschluss (3) der Ausgangsleitung Ls der Testsignaleingang (T) ist, wobei der Ultrahochfrequenzsignal-Ausgangsanschluss (2) der Ausgangsleitung Ls der Ultrahochfrequenzsignal-Ausgang (S) ist, der entweder das Nutzsignal (Ue), das vom verteilten Verstärker (Amp1) verstärkt wird, wenn die Verstärkungszellen des verteilten Verstärkers im verstärkenden Zustand sind, oder das Testsignal (St) zuführt, das von der Ausgangsleitung (Ls) übertragen wird, wenn die Verstärkungszellen in den gesperrten Zustand gesetzt sind und das Testsignal (St) an den Testsignaleingang (T) der Ausgangsleitung (Ls) angelegt wird.

3. Elektronische Ultrahochfrequenz-Schaltstruktur nach Anspruch 1, **dadurch gekennzeichnet, dass** sie einen ersten (Amp1) und einen zweiten (Amp2) verteilten Verstärker umfasst, die relativ zu einer gemeinsamen Ausgangsleitung (Ls1) symmetrisch sind, zum Bilden von zwei Verstärkungssignalkanälen (q=2), einem Kanal für das Nutzsignal (Ue) und einem Kanal für das Testsignal (St), wobei die verteilten Verstärker jeweils eine erste (g1) und eine zweite (g2) Gruppe von Verstärkungszellen sowie eine erste (Le1) und eine zweite (Le2) Eingangsleitung haben,
wobei der Ultrahochfrequenzsignal-Eingangsanschluss (3) der gemeinsamen Ausgangsleitung (Ls1) mit einer Ausgangsleitungslast (Zd) verbunden ist, wobei der Ultrahochfrequenzsignal-Ausgangsanschluss (2) der Ausgangsleitung (Ls1) der Ultrahochfrequenzsignal-Ausgang (S1) ist,
wobei der Nutzsignal-(Ue)-Eingang (E1) der Eingangsanschluss (11) der ersten Eingangsleitung (Le1) ist, der mit der ersten Gruppe (g1) von Verstärkungszellen und der gemeinsamen Ausgangsleitung (Ls1) den ersten verteilten Verstärker (Amp1) des Nutzsignals (Ue) bildet,
wobei der Testsignal-(St)-Eingang (T) der Eingangsanschluss (12) der zweiten Eingangsleitung (Le2) ist, der mit der zweiten Gruppe (g2) von Verstärkungszellen und der gemeinsamen Ausgangsleitung (Ls) den zweiten verteilten Verstärker (Amp2) des Testsignals (St) bildet,
wobei der Ultrahochfrequenzsignal-Ausgang (S1) entweder das verstärkte Nutzsignal (Ue), wenn die Verstärkungszellen der ersten Gruppe (g1) im Verstärkungszustand sind und die der zweiten Gruppe (g2) im gesperrten Zustand sind, oder das Testsignal (St) zuführt, wenn die Verstärkungszellen der ersten Gruppe im gesperrten Zustand sind und die der zweiten Gruppe im Verstärkungszustand sind und das Testsignal (St) an den Eingangsanschluss (12) der zweiten Eingangsleitung (Le2) angelegt wird.

4. Elektronische Ultrahochfrequenz-Schaltstruktur nach Anspruch 1, **dadurch gekennzeichnet, dass** sie einen ersten (Amp1) und einen zweiten (Amp2) verteilten Verstärker umfasst, die relativ zu einer gemeinsamen Ausgangsleitung (Ls1) symmetrisch sind, zum Bilden von drei Signalkanälen (q=3), einem ersten Verstärkungskanal für ein erstes Nutzsignal (Ue1), einem zweiten Verstärkungskanal für ein zweites Nutzsignal (Ue2) und einem dritten passiven Kanal für das Testsignal (St), wobei die verteilten Verstärker jeweils eine erste (g1) und eine zweite (g2) Gruppe von Verstärkungszellen sowie eine erste (Le1) und eine zweite (Le2) Eingangsleitung haben,
wobei der Ultrahochfrequenzsignal-Eingangsanschluss (3) der gemeinsamen Ausgangsleitung (Ls1) der Testsignal-(St)-Eingang (T) ist, wobei der Ultrahochfrequenzsignal-Ausgangsanschluss (2) der Ausgangsleitung (Ls1) der Ultrahochfrequenzsignal-Ausgang (S1) ist,
wobei der Eingang (E1) eines ersten Nutzsignals (Ue1) der Eingangsanschluss (11) der ersten Eingangsleitung (Le1) ist, der mit der ersten Gruppe (g1) von Verstärkungszellen und der gemeinsamen Ausgangsleitung (Ls1) den ersten verteilten Verstärker (Amp1) des ersten Nutzsignals (Ue1) bildet,
wobei der Eingang (E2) eines zweiten Nutzsignals (Ue2) der Eingangsanschluss (12) der zweiten Eingangsleitung (Le2) ist, der mit der zweiten Gruppe (g2) von Verstärkungszellen und der gemeinsamen Ausgangsleitung (Ls1) den zweiten verteilten Verstärker (Amp2) des zweiten Nutzsignals (Ue2) bildet,
wobei der Ultrahochfrequenzausgang (S1) entweder das erste verstärkte Nutzsignal (Ue1), wenn die Verstärkungszellen der ersten Gruppe (g1) in den Verstärkungszustand und die der zweiten Gruppe (g2) in den gesperrten Zustand gesetzt sind, oder das zweite verstärkte Nutzsignal (Ue2) zuführt, wenn die Verstärkungszellen der ersten Gruppe (g1) in den gesperrten Zustand gesetzt sind und die der zweiten Gruppe (g2) in den Verstärkungszustand gesetzt sind, oder das Testsignal (St), wenn die Verstärkungszellen der ersten und der zweiten Gruppe in den gesperrten Zustand gesetzt sind und das Testsignal (St) an den Eingangsanschluss (3) der gemeinsamen Ausgangsleitung (Ls1) angelegt wird.

5. Elektronische Ultrahochfrequenz-Schaltstruktur nach Anspruch 3, **dadurch gekennzeichnet, dass** sie zusätzlich zum ersten (Amp1) und zum zweiten (Amp2) verteilten Verstärker, die eine erste Teilmenge (SE1) von verteilten Verstärkern bilden, den Ultrahochfrequenzsignal-Ausgang (S1), einen dritten (Amp3) und einen vierten (Amp4) verteilten Verstärker umfassen, die eine zweite Teilmenge (SE2) von verteilten Verstärkern bilden, die mit der ersten Teilmenge relativ zur zweiten Eingangsleitung (Le2c) symmetrisch ist, die den beiden Teilmengen (SE1, SE2) gemeinsam ist, zum Bilden von vier Verstärkungssignalkanälen (q=4), zwei Verstärkungskanälen, die jeweils ein jeweiliges Nutzsignal (Ue1, Ue2) verstärken, und zwei weiteren Verstärkungskanälen für das Testsignal (St), wobei der dritte und der vierte verteilte Verstärker jeweils eine dritte (g3) und eine vierte (g4) Gruppe von Verstärkungszellen umfassen, wobei die zweite Teilmenge (SE2) einen weiteren Ultrahochfrequenzsignal-Ausgang (S2) umfasst,
wobei die beiden symmetrischen Teilmengen (ES1, ES2) die zweite gemeinsame Eingangsleitung (Le2c) haben, wobei der Eingangsanschluss (33) der zweiten gemeinsamen Eingangsleitung (Le2c) der Testsignaleingang (T) ist,
wobei der andere Ultrahochfrequenzausgang (S2) der zweiten Teilmenge (ES2) Folgendes zuführt:
entweder ein weiteres verstärktes Nutzsignal (Ue2), das an einen weiteren Eingang (E2) der ersten Eingangsleitung (Le1) der zweiten Teilmenge (ES2) angelegt wird, wenn die Verstärkungszellen der vierten Gruppe (g4) von Verstärkungszellen der zweiten Teilmenge (ES2) in den Verstärkungszustand gesetzt sind und die der dritten Gruppe (g3) der zweiten Teilmenge (ES2) in den gesperrten Zustand gesetzt sind,
oder das Testsignal (St), wenn die Verstärkungszellen der dritten Gruppe (g3) von Verstärkungszellen der zweiten Teilmenge (ES2) in den Verstärkungszustand gesetzt sind und die der vierten Gruppe (g4) der zweiten Teilmenge (ES2) in den gesperrten Zustand gesetzt sind, und das Testsignal (St) an den Eingangsanschluss (33) der zweiten gemeinsamen Eingangsleitung (Le2c) angelegt wird.

6. Elektronische Ultrahochfrequenz-Schaltstruktur nach einem der Ansprüche 1 bis 5, **dadurch gekennzeichnet, dass** die Lastanschlüsse (4, 41, 42, 43) der Eingangsleitungen (Le, Le1, Le2, Le2c) mit einer Impedanz (Zg) verbunden sind, die für die Eingangsleitungen charakteristisch ist.

## Claims

1. An microwave frequency electronic switching structure comprising at least one wanted signal input(E, E1, E2, Ex) that is designed to receive a wanted signal (Ue, Ue1, Ue2), a test signal input (T) that is designed to receive a test signal (St) and at least one microwave frequency signal output (S, S1, S2),
**characterised in that** it comprises n distributed amplifiers (Amp1, Amp2,...Ampi,...Ampn), n being greater than or equal to 1, for forming q signal channels, q being greater than or equal to 2, each distributed amplifier comprising a group (g1, g2,...gi,...gn) of amplifying cells (Cs1, Cs2,..Csk,...Csp) that are distributed between an input line (Le, Le1, Le2, Le2c) and an output line (Ls, Ls1, Ls2),
the input line having an microwave frequency signal input terminal (1, 11, 12) at one of its ends and a load terminal at the other end (4, 41, 42, 43),
the output line having, on the load terminal side of said input line, an microwave frequency signal output terminal (2, 21, 22) at one of its ends and an microwave frequency signal input terminal (3, 31) at the other end,
said microwave frequency signal input terminal (1, 11, 12) of at least one of said input lines (Le, Le1, Le2) of a distributed amplifier being the input (E, E1, E2) for a wanted signal (Ue, Ue1, Ue2), the microwave frequency signal input terminal of another of the lines being the test signal (St) input (T), the microwave frequency signal output terminal of at least one of the output lines (Ls, Ls1, Ls2) being the microwave frequency signal output (S, S1, S2),
each of said amplifying cells (Cs1, Cs2,..Csk,...Csp) comprising a control input Cd for placing said amplifying cells of a group (g1, g2,...gi,...gn) either in an amplifying state or in a blocked state, independently of another group, so as to carry out a transmission at the microwave frequency signal output (S, S1, S2) either of the amplified wanted signal (Ue, Ue1, Ue2) or of the test signal (St),
a control unit UC for controlling the amplifying cells of each of the groups either in the amplifying state or in the blocked state.

2. The microwave frequency electronic switching structure according to claim 1, **characterised in that** it comprises a single distributed amplifier (n=1) for forming two signal channels (q=2), one amplifying signal channel for the wanted signal (Ue) and one non-amplifying channel (passive channel) for a test signal St, the microwave frequency signal input terminal (3) of the output line Ls being the test signal input (T), the microwave frequency signal output terminal (2) of the output line Ls being the microwave frequency signal output (S) supplying either the wanted signal (Ue) that is amplified by the distributed amplifier (Amp1) when said amplifying cells of said distributed amplifier are placed in the amplifying state or the test signal (St) that is transmitted by said output line (Ls) when said amplifying cells are placed in the blocked state and the test signal (St) is applied to the test signal (T) input of said output line (Ls).

3. The microwave frequency electronic switching structure according to claim 1, **characterised in that** it comprises a first (Amp1) and a second (Amp2) distributed amplifier, which are symmetrical relative to a common output line (Ls1), for forming two amplifying signal channels (q=2), one channel for the wanted signal (Ue) and one channel for the test signal (St), said distributed amplifiers respectively having a first (g1) and a second (g2) group of amplifying cells and a first (Le1) and a second (Le2) input line,
the microwave frequency signal terminal input (3) of said common output line (Ls1) being connected to an output line (Zd) load, said microwave frequency signal terminal output (2) of said output line (Ls1) being the microwave frequency signal output (S1),
the wanted signal (Ue) input (E1) being the input terminal (11) of the first input line (Le1) forming, with the first group (g1) of amplifying cells and the common output line (Ls1), the first distributed amplifier (Amp1) of the wanted signal (Ue),
the test signal (St) input (T) being the input terminal (12) of the second input line (Le2) forming, with the second group (g2) of amplifying cells and the common output line (Ls), the second (Amp2) distributed amplifier of the test signal (St),
the microwave frequency signal output (S1) supplying either the amplified wanted signal (Ue) when the amplifying cells of the first group (g1) are placed in the amplifying state and the amplifying cells of the second group (g2) are placed in the blocked state, or the test signal (St) when the amplifying cells of the first group are placed in the blocked state and the amplifying cells of the second group are placed in the amplifying state, and the test signal (St) is applied to the input terminal (12) of said second input line (Le2).

4. The microwave frequency electronic switching structure according to claim 1, **characterised in that** it comprises a first (Amp1) and a second (Amp2) distributed amplifier, which are symmetrical relative to a common output line (Ls1), for forming three signal channels (q=3), a first amplifying channel for a first wanted signal (Ue1), a second amplifying channel for a second wanted signal (Ue2) and a third passive channel for the test signal (St), said distributed amplifiers respectively having a first (g1) and a second (g2) group of amplifying cells and a first (Le1) and a second (Le2) input line,
the microwave frequency signal input terminal (3) of said common output line (Ls1) being the test signal (St) input (T), the microwave frequency signal output terminal (2) of the output line (Ls1) being the microwave frequency signal output (S1),
the input (E1) of a first wanted signal (Ue1) being the input terminal (11) of the first input line (Le1) forming, with the first group (g1) of amplifying cells and the common output line (Ls1), the first distributed amplifier (Amp1) of the first wanted signal (Ue1),
the input (E2) of a second wanted signal (Ue2) being the input terminal (12) of the second input line (Le2) forming, with the second group (g2) of amplifying cells and the common output line (Ls1), the second distributed amplifier (Amp2) of the second wanted signal (Ue2),
the microwave frequency signal output (S1) supplying either the first amplified wanted signal (Ue1) when the amplifying cells of the first group (g1) are placed in the amplifying state and the amplifying cells of the second group (g2) are placed in the blocked state, or the second amplified wanted signal (Ue2) when the amplifying cells of the first group (g1) are placed in the blocked state and the amplifying cells of the second group (g2) are placed in the amplifying state, or the test signal (St) when the amplifying cells of the first and second groups are placed in the blocked state, and the test signal (St) is applied to the input terminal (3) of the common output line (Ls1).

5. The microwave frequency electronic switching structure according to claim 3, **characterised in that** it comprises, in addition to the first (Amp1) and the second (Amp2) distributed amplifiers forming a first sub-set (SE1) of distributed amplifiers comprising the microwave frequency signal output (S1), a third (Amp3) and a fourth (Amp4) distributed amplifier, forming a second sub-set (SE2) of distributed amplifiers that are symmetrical to the first sub-set relative to the second input line (Le2c) that is common to the two sub-sets (SE1, SE2), for forming four amplifying signal channels (q=4), two amplifying channels each amplifying a respective wanted signal (Ue1, Ue2) and two further amplifying channels for the test signal (St), the third and fourth distributed amplifiers respectively comprising a third (g3) and fourth (g4) group of amplifying cells, the second sub-set (SE2) comprising a further microwave frequency signal output (S2),
the two symmetrical sub-sets (ES1, ES2) having the second common input line (Le2c), the input terminal (33) of the second common input line (Le2c) being the test signal input (T),
the other microwave frequency output (S2) of said second sub-set (ES2) supplying:
either a further amplified wanted signal (Ue2) applied to a further input (E2) of the first input line (Le1) of said second sub-set (ES2) when the amplifying cells of the fourth group (g4) of amplifying cells of said second sub-set (ES2) are placed in the amplifying state and the amplifying cells of the third group (g3) of said second sub-set (ES2) are placed in the blocked state,
or the test signal (St) when the amplifying cells of the third group (g3) of amplifying cells of said second sub-set (ES2) are placed in the amplifying state and the amplifying cells of the fourth group (g4) of said second sub-set (ES2) are placed in the blocked state and the test signal (St) is applied to the input terminal (33) of the second common input line (Le2c).

6. The microwave frequency electronic switching structure according to any one of claims 1 to 5, **characterised in that** the load terminals (4, 41, 42, 43) of the input lines (Le, Le1, Le2, Le2c) are connected to a characteristic impedance (Zg) of said input lines.
